# EUROPEAN PATENT APPLICATION

(11) **EP 2 101 219 A1**
(43) Date of publication of application: **16.09.2009**
(21) Application number: 09003683.1
(22) Date of filing: 13.03.2009
(51) Int. Cl.: G03F 7/42

(54) **Stripper for copper/low K BEOL clean**

(30) Priority: 14.03.2008 US 36707 P; 09.03.2009 US 400332
(71) Applicant: Air Products and Chemicals, Inc., Allentown, PA 18195-1501 (US)
(72) Inventor: Lee, Yi-Chia, Dansheui Jem 251 (TW); Liu, Wen Dar, Chupei City Hsinchu Hsien 302 (TW); Liao, Archie, Taipei 104 (TW); Egbe, Matthew I., West Norriton, PA 19403 (US); Rao,Madhukar Bhaskara, Fogelsville, PA 18051 (US); Legenza, Michael Walter, Bellingham, MA 02019 (US); Sheu, Chimin, Taipei 300 (TW)
(74) Representative: Sommer, Andrea

(57) **Abstract**

The present invention is a chemical stripper formulation for removing photoresist and the residue of etching and ashing of electronic device substrates, comprising: deionized water, acetic acid, polyethylene glycol, dipropylene glycol monomethyl ether and ammonium fluoride. The present invention is also a process for removing photoresist and the residue of etching and ashing of electronic device substrates by contacting the substrate with a formulation, comprising: deionized water, acetic acid, polyethylene glycol, dipropylene glycol monomethyl ether and ammonium fluoride.

## Description

### CROSS-REFERENCE TO RELATED APPLICATIONS

This Application claims the benefit of Provisional Application No 61/036,707, filed on March 14, 2008.

### BACKGROUND OF THE INVENTION

In the manufacture of semiconductor circuits on wafers, the wafers are periodically coated with photoresist to fabricate the various layers of circuitry, electrical devices and vias and interconnects. After photoresist is developed and used, etching and ashing are performed, resulting in residues that must be removed before further processing. Strippers have been utilized to remove unwanted photoresist and the residues of etching and ashing. The photoresist, etch residue or ash residue is difficult to selectively remove without damaging the desired circuit structures. The stripper must be compatible with dielectric and metal conductive materials. The corrosion rate of either of these differing types of materials must be within acceptable levels during any stripping process.

Addressing the above stated problem, the present invention, as described below, overcomes these existing problems in the art with a new low pH, fluoride stripper for cleaning Cu/Low k patterned wafer. Compared with commercial fluoride strippers, this platform has comparable clean performance, etch rates on metal / dielectric substrates w/ lower k-shift.

### BRIEF SUMMARY OF THE INVENTION

The present invention is a chemical stripper formulation for removing photoresist and the residue of etching and ashing of electronic device substrates, comprising: deionized water; a carboxylic acid, such as acetic acid; a glycol, such as polyethylene glycol; a glycol ether, such as dipropylene glycol monomethyl ether; and a fluoride, such as ammonium fluoride.

The present invention is also a process for removing photoresist and the residue of etching and ashing of electronic device substrates by contacting the substrate with a formulation, comprising: deionized water; a carboxylic acid, such as acetic acid; a glycol, such as polyethylene glycol; a glycol ether, such as dipropylene glycol monomethyl ether; and a fluoride, such as ammonium fluoride.

### BRIEF DESCRIPTION OF SEVERAL VIEWS OF THE DRAWINGS

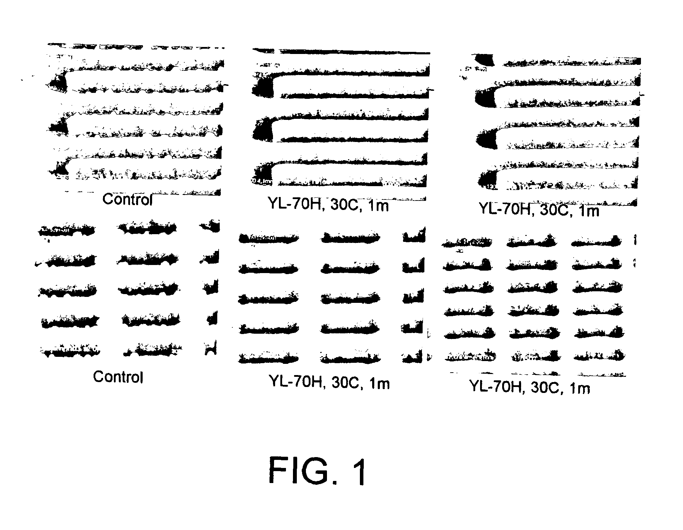

FIG 1 is two sets of three scanning electron micrographs (SEM) of a patterned electronic device substrate before stripping with the present invention and after treatment with the present invention.

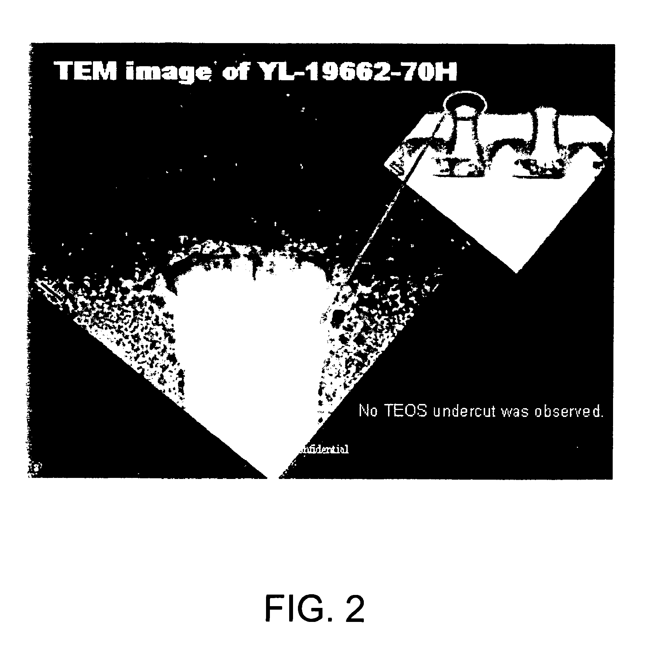

FIG 2 is an SEM of a single geometry or hole on an electronic device substrate comprising a film deposited from TEOS after cleaning with the present invention.

### DETAILED DESCRIPTION OF THE INVENTION

A new platform of low pH, fluoride stripper was provided for cleaning Cu/Low k patterned wafer. Compared with commercial fluoride strippers, this platform has lower pH value. Comparable clean performance, etch rates on metal / dielectric substrates with lower k-shift were observed with this formulation This formulaton provides lower k-shift after wet stripping compared to all commercial stripper products. This is used on Back End Of Line (BEOL) copper and porous low k dielectric film composites cleaning. An embodiment of the present invention stripper in accordance with this platform is set forth in Table 1, below.

**Table 1**

| YL-19662-70H | |
|---|---|
| Grams needed | 100.00 |
| DIW | 90.00 |
| Acetic Acid | 0.50 |
| PG | 4.40 |
| DPM | 5.00 |
| NH₄F (40%) | 0.10 |

No acetate salt was added to keep salt content low to prevent dielectric constant increase. Therefore, the pH value of this formulation was shifted down to pH 3.0, much more acidic than other commercial fluoride strippers.

To maintain low etch rate on films deposited from precursors: tetraethylorthosilicate (TEOS) and porous diethymethylsilane (pDEMS), fluoride content was reduced down to 0.1 gram and the [H]/[F] ratio is high.

Dipropylene glycol monomethyl ether (DPM) and polyethylene glycol (PG) were added to help dissolve organic residue. Deionized water (DIW) is the predominant phase.

**Table 2 etch rate of YL-70H on various substrates**

| Etch Rate (A/min) | Cu | AP pDEMS 2.5 | TEOS (densified) | TEOS (undensified) |
|---|---|---|---|---|
| YL-19662-70H | 4.5 | 0.1 | 0.1 | 0.15 |

AP pDEMS 2.5 is a dielectric film deposited from diethoxymethylsilane and a porogen to produce a porous dielectric film when the porogen is removed to leave pores where the porogen was in the film, resulting in a dielectric value of 2.5. The diethoxymethylsilane and porogen are available from Air Products and Chemicals, Inc. of Allentown, PA, USA.

Exemplary carboxylic acids include, but are not limited to, acetic acid, propionic acid, butyric acid, valeric acid, octanoic acid, decanoic acid, dodecanoic acid, stearic acid, dodecanedioic acid, 2-methylheptanoic acid, 2-hexyldecanoic acid, oxalic acid, malonic acid, maleic acid, fumaric acid, succinic acid, itaconic acid, glutaric acid, adipic acid, malic acid, tartaric acid, acrylic acid, methacrylic acid, citric acid, lactic acid, glycolic, anthranilic acid, gallic acid, benzoic acid, isophthalic acid, phthalic acid, trimellitic acid, pyromellitic acid, salicylic acid, 2,4-dihydroxy benzoic acid and others. Preferably the carboxylic acid is a lower alkyl carboxylic acid.

Examples of suitable alkyl groups include; methyl, ethyl, propyl, isopropyl, butyl, isobutyl and tertbutyl. The expression "lower alkyl" refers to alkyl groups of 1 to 4 carbon atoms.

Examples of glycol ethers that can be used in the present invention include ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl either, diethylene glycol monobenzyl ether, diethylene glycol dimethyl ether, diethylene glycol diethyl ether, triethylene glycol monomethyl ether, triethylene glycol dimethyl ether, polyethylene glycol monomethyl ether, diethylene glycol methyl ethyl ether, triethylene glycol ethylene glycol monomethyl ether acetate, ethylene glycol monethyl ether acetate, propylene glycol methyl ether acetate, propylene glycol monomethyl ether, propylene glycol dimethyl ether, propylene glycol monobutyl ether, propylene glycol, monopropyl ether, dipropylene glycol monomethyl ether, dipropylene glycol monopropyl ether, dipropylene glycol monoisopropyl ether, dipropylene monobutyl ether, diproplylene glycol diisopropyl ether, tripropylene glycol monomethyl ether, 1-methoxy-2-butanol, 2-methoxy-1-butanol, 2-methoxy-2-methylbutanol, 1,1-dimethoxyethane and 2-(2-butoxyethoxy) ethanol.

Polyhydric alcohol used in the present invention are preferably mono- , di- or trialcohols, such as(C₄- C₂₀) alkanols, (C₂- C₂₀) alkanediols and (C₃- C₂₀) alkanetriols, cyclic alcohols and substituted alcohols. Exemplary alcohols include; glycerol, ethylene glycol, propylene glycol, diethylene glycol, dipropylene glycol, hexylene glycol, 1,2-butandiol, 1,4-butandiol, 2,3-butandiol, benzyl alcohol, tetrahydrofurfuryl alcohol, 1-octanol, diacetone alcohol and 1, 4-cyclohexanedimethanol.

Fluoride is present in the compositions described herein. Fluoride-containing compounds include those of the general formula R₁R₂R₃R₄NF where R₁, R₂, R₃, and R₄ are independently hydrogen, an alcohol group, an alkoxy group, an alkyl group or mixtures thereof. Examples of such compounds are ammonium fluoride, tetramethyl ammonium fluoride, tetraethyl ammonium fluoride. Fluoroboric acid can also be used as the fluoride compounds. Still further examples of fluoride-containing compounds include fluoroboric acid, hydrofluoric acid, and choline fluoride. The fluoride is preferably present in amounts of from 0.001 % by weight to 20% by weight or from 0.1% by weight to 10% by weight. Ammonium fluoride is preferred in an amount of 0.01 wt% of a 40% concentration in water. In these embodiments, ammonium fluoride may be available commercially as a 40% aqueous solution.

Water is present as an element of the present invention. It can be present coincidentally as a component of other elements of the invention such as an aqueous ammonium fluoride solution, or it can be added separately. Preferably, water is present in amounts of from 0.5% by weight to 90% by weight. In certain embodiments, the presence of water may improve the solubility of ammonium fluoride in the compositions of the present invention and aids in the removal of photoresist and cleaning of inorganic etch residues.

Corrosion inhibitors in an amount of up to 20% by weight can be added to compositions of the present invention. Preferably, the inhibitor concentration is from about 0.5% by weight to 8% by weight. Any corrosion inhibitor known in the art for similar applications, such as those disclosed in U.S. Pat. No. 5,417,877 which are incorporated herein by reference may be used. In certain embodiments, it has been found that inhibitor compositions with a pKa greater than 6 do not function as well as inhibitor compositions having a pKa of less than about 6 in systems with a pH range of about 3 to about 6. Therefore, preferred inhibitor compositions are those having a pKa of about 6 or less. Corrosion inhibitors may be an organic acid, an organic acid salt, a phenol, a triazole, or a hydroxylamine. Examples of preferred inhibitor compositions include anthranilic acid, gallic acid, benzoic acid, isophthalic acid, maleic acid, fumaric acid, D,L-malic acid, malonic acid, phthalic acid, maleic anhydride, phthalic anhydride, carboxybenzotriazole, diethyl hydroxylamine and the lactic acid and citric acid salts thereof, and the like. Further examples of corrosion inhibitors that may be used include catechol, pyrogallol, and esters of gallic acid.

In certain embodiments, a pH ranging from about 3 to about 9, or ranging from about 3 to about 7, or ranging from about 3 to about 6 will allow most sensitive metals to passivate with minimum corrosion. Removal of highly inorganic etch residues and oxide skimming may require a slightly acidic pH. The pH of the composition disclosed herein is adjusted 3 for best efficacy for cleaning etch residue and passivation of metals.

The invention further relates to the following items:
1. A chemical stripper formulation for removing photoresist and the residue of etching and ashing of electronic device substrates, comprising: deionized water, carboxylic acid, glycol, glycol ether and a fluoride.
2. The formulation of Item 1 comprises deionized water, acetic acid, polyethylene glycol, dipropylene glycol monomethyl ether and ammonium fluoride.
3. The formulation of Item 1 wherein the formulation contains the recited amounts of the components of the formulation:

| | |
|---|---|
| DIW | 90.00 |
| Acetic Acid | 0.50 |
| PG | 4.40 |
| DPM | 5.00 |
| NH₄F (40%) | 0.10 |

4. A process for removing photoresist and the residue of etching and ashing of electronic device substrates by contacting the substrate with a formulation, comprising: deionized water, carboxylic acid, glycol, glycol ether and a fluoride.
5. The formulation of Item 4 comprises deionized water, acetic acid, polyethylene glycol, dipropylene glycol monomethyl ether and ammonium fluoride.
6. The process of Item 5 wherein the formulation contains the recited amounts of the components of the formulation:

| | |
|---|---|
| DIW | 90.00 |
| Acetic Acid | 0.50 |
| PG | 4.40 |
| DPM | 5.00 |
| NH₄F (40%) | 0.10 |

## Claims

1. A chemical stripper formulation for removing photoresist and the residue of etching and ashing of electronic device substrates, comprising: deionized water, carboxylic acid, glycol, glycol ether and a fluoride.

2. The formulation of Claim 1 comprises deionized water, acetic acid, polyethylene glycol, dipropylene glycol monomethyl ether and ammonium fluoride.

3. The formulation of Claims 1 or 2, wherein the formulation contains the recited amounts of the components of the formulation:
| | |
|---|---|
| DIW | 90.00 |
| Acetic Acid | 0.50 |
| PG | 4.40 |
| DPM | 5.00 |
| NH₄F (40%) | 0.10 |

4. A process for removing photoresist and the residue of etching and ashing of electronic device substrates by contacting the substrate with a formulation according to claims 1 to 3.
